# EUROPEAN PATENT APPLICATION

(11) **EP 4 621 922 A1**
(43) Date of publication of application: **24.09.2025**
(21) Application number: 24164811.2
(22) Date of filing: 20.03.2024
(51) Int. Cl.: H01M 10/42, G01R 31/385, H01M 10/6566, G01R 31/396, H01M 10/48

(54) **TESTING OF BATTERY CELLS**

(71) Applicant: Proventia Oy, 90460 Oulunsalo (FI)
(72) Inventor: Kervinen, Harri, Oulunsalo (FI); Ontto-Panula, Jyrki, Oulunsalo (FI); Remes, Samuli, Oulunsalo (FI); Holopainen, Erkki, Oulunsalo (FI); Lantto, Jouni, Oulunsalo (FI)
(74) Representative: Espatent Oy

(57) **Abstract**

A modular test facility for testing of battery cells, comprising a container (10) having a floor, walls and a roof; at least one rack arrangement (30) in the container configured to support a plurality of battery cells (20) being tested spaced from each other in rows and stacks; an arrangement (40) configured to provide an airflow into a first channel (50); wherein the first channel (50) comprises at least one outlet opening (70) configured to guide the airflow into at least one second channel (60); characterized in that the at least one second channel (60) comprises a plurality of first flow guide elements (90A) configured to guide the flow into a third channel (80) and divide the flow into separate downward flows for each stack of battery cells, wherein the mass flow of each downward flow is substantially same; and in that the third channel (80) comprises a plurality of second flow guide elements (90B) configured to guide the downward flow into a horizontal flow on or around each battery cell in such a way that the mass flow of the flow on or around each battery cell is substantially same.

## Description

### TECHNICAL FIELD

The present disclosure generally relates to testing of battery cells. The disclosure relates particularly, though not exclusively, to performance and lifetime testing of battery cells. The disclosure relates particularly, though not exclusively, to a modular test facility for testing of battery cells.

### BACKGROUND

This section illustrates useful background information without admission of any technique described herein representative of the state of the art.

Production of battery cells requires rigorous testing in order to ensure the quality of the battery cells produced. Typically, each produced battery cell is tested with a test charge and discharge and by measuring some electric quantities. Furthermore, some battery cells produced undergo a more stringent performance and lifetime testing.

Performance and lifetime testing of battery cells is carried out in standardized conditions that re kept constant and same for each cell. Accordingly, a test facility for lifetime testing of battery cells typically requires a large amount of space and equipment for controlling the conditions.

The present disclosure aims to provide a modular test facility for performance and lifetime testing of battery cells that is easy to operate, cost effective and space saving.

### SUMMARY

The appended claims define the scope of protection. Any examples and technical descriptions of apparatuses, products and/or methods in the description and/or drawings not covered by the claims are presented not as embodiments of the invention but as background art or examples useful for understanding the invention.

According to a first example aspect there is provided a modular test facility for testing of battery cells, comprising
a container having a floor, walls and a roof;
at least one rack arrangement in the container configured to support a plurality of battery cells being tested spaced from each other in rows and stacks;
an arrangement configured to provide an airflow into a first channel; wherein the first channel comprises at least one outlet opening configured to guide the airflow into at least one second channel; wherein
the at least one second channel comprises a plurality of first flow guide elements configured to guide the flow into a third channel and divide the flow into separate downward flows for each stack of battery cells, wherein the mass flow of each downward flow is substantially same; and wherein
the third channel comprises a plurality of second flow guide elements configured to guide the downward flow into a horizontal flow on or around each battery cell in such a way that the mass flow of the flow on or around each battery cell is substantially same.

The at least one second channel may further comprise after the inlet opening third flow guide elements configured to function as flow dampeners controlling the volume flow in the second channel prior to the first flow guide elements.

The modular test facility may further comprise an arrangement for connecting each battery cell being tested to a testing system for cell charging and discharging, control and measurement.

The modular test facility may further comprise a quick-loading single-cell contactor configured to be adjustable for different types of cells for attaching a battery cell to the testing system.

The rack arrangement may be configured to enable loading and unloading therefrom and connecting and disconnecting each battery cell being tested without affecting the neighbouring cells being tested.

The modular test facility may further comprise in the test chamber within the container a fire detection and suppression system, a gas detection system, a video monitoring system and/or a control system with a user interface for operating the test facility.

According to a second example aspect there is provided a method of controlling the conditions of a test facility for testing battery cells, comprising
providing at least one rack arrangement configured to support a plurality of battery cells being tested spaced from each other in rows and stacks in a container;
providing an airflow into a first channel;
guiding the airflow into at least one second channel via at least one inlet opening;
guiding the flow into a third channel and dividing the flow into separate downward flows for each stack of battery cells, wherein the mass flow of each downward flow is substantially same with a plurality of first flow guide elements; and
guiding the downward flow into a horizontal flow on or around each battery cell in such a way that the mass flow of the flow on or around each battery cell is substantially same with a plurality of second flow guide elements.

The method of controlling the conditions of a test facility for testing battery cells may further comprise dampening the air flow in the at least one second channel with third flow guide elements prior to the first flow guide elements.

Different non-binding example aspects and embodiments have been illustrated in the foregoing. The embodiments in the foregoing are used merely to explain selected aspects or steps that may be utilized in different implementations. Some embodiments may be presented only with reference to certain example aspects. It should be appreciated that corresponding embodiments may apply to other example aspects as well.

### BRIEF DESCRIPTION OF THE FIGURES

Some example embodiments will be described with reference to the accompanying figures, in which:
Fig. 1 shows a schematic side view of a test facility for testing battery cells according to an example embodiment;
Fig. 2 shows a schematic partial cross sectional view of a test facility for testing battery cells according to an example embodiment;
Fig. 3 shows a schematic top view of a test facility for testing battery cells according to an example embodiment; and
Fig. 4 shows a flow chart of a method of controlling the conditions of a test facility for testing battery cells according to an example embodiment.

### DETAILED DESCRIPTION

In the following description, like reference signs denote like elements or steps.

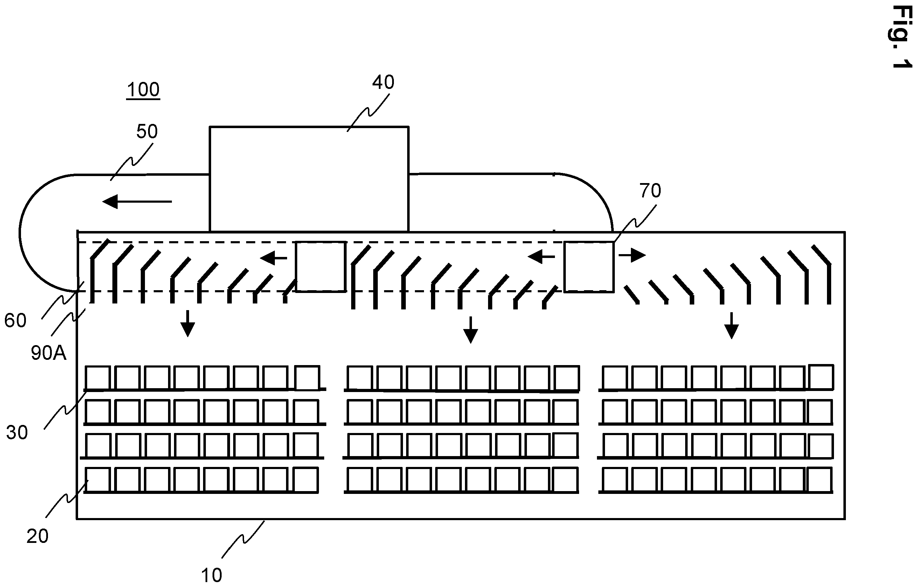

Fig. 1 shows a schematic side view of a test facility 100 for testing battery cells according to an example embodiment.

The modular test facility 100 comprises a container, or module, 10 having a floor, walls and a roof. Hereto it is noted that the container in an example embodiment refers to any type of room, or closed space, forming a test chamber therein, and is not necessarily a container of any specific type. In an example embodiment, the container 10 comprises a movable module that is configured to be transported to a location in which the testing facility is to be operated. In a further example embodiment, the container 10 comprises a standard sized container, such as a standard shipping container as a platform on top of which the structures of the test facility are built.

The test facility comprises at least one rack arrangement 30 configured to accommodate and support a plurality of battery cells 20 to be tested. In an example embodiment, the rack arrangement 30 is configured to support the battery cells 20 on several levels next to each other. The battery cells 20 are supported on racks in rows and there are several racks on top of each other. Accordingly, there are rows and stacks of batter cells 20. Fig. 1 shows an example arrangement with each rack supporting eight battery cells 20 being tested next to each other and with four racks on top of each other. Accordingly, in the example of Fig. 1 there are three rack arrangements 30 supporting 32 cells each on both long sides of the test chamber in the container 10. In a further example there are three rack arrangements 30 on both long sides of the container 10, each rack arrangement supporting a number of battery cells different from eight 10 being tested.

In an example embodiment, the rack arrangement 30 is configured to support different type of battery cells 20 being tested. In an example embodiment, the different types of battery cells 20 comprise large prismatic cells, large pouch cells or cylindrical cells.

The rack arrangement 30 further comprises (not shown) an arrangement for connecting each battery cell 20 being tested to a testing system for cell charging and discharging, control and measurement. In an example embodiment, each battery cell is attached to the testing system using a quick-loading single-cell contactor configured to be adjustable for different types of cells. In an example embodiment, the rack arrangement 30 is configured to enable loading and unloading from the rack and connecting and disconnecting each battery cell 20 being tested without affecting the neighbouring cells being tested.

In an example embodiment, the testing chamber within the container 10 comprises further elements that are no shown in the schematic presentation of Figs. 1-3. In an example embodiment, the container 10 comprises a door for entering the test chamber. In an example embodiment, the test chamber comprises a fire detection and suppression system, a gas detection system, a video monitoring system and a control system with a user interface for operating the test facility.

The test facility 100 further comprises a system for controlling the environment inside the container in such a way that each battery cell 20 being tested is tested in the same conditions, for example in the same temperature. For this purpose, colling of battery cells being tested is provided. The test facility 100 comprises an arrangement 40 for providing an airflow. In an example embodiment, the arrangement for providing the airflow 40 comprises a ventilator. In an example embodiment, the arrangement 40 for providing an air flow is positioned on the roof of the container 10.

The test facility 100 further comprises channels for directing the air flow on and around each battery cell 20 being tested. The air flow generated by the arrangement 40 is first guided into a first channel 50 running horizontally from the arrangement 40 on the roof of the container 10 and then turning at the end of the container 10 to run further horizontally on top of the test chamber on both sides thereof within the container 10. The directions of air flow are schematically shown with arrow in Fig. 1.

The first channel 50 comprises at least one outlet opening 70 configured to guide the airflow from the first channel 50 into at least one second channel 60. The at least one second channel 60 comprises a horizontal channel running on top of the test chamber between the first channel 50 and the wall of the container 10.

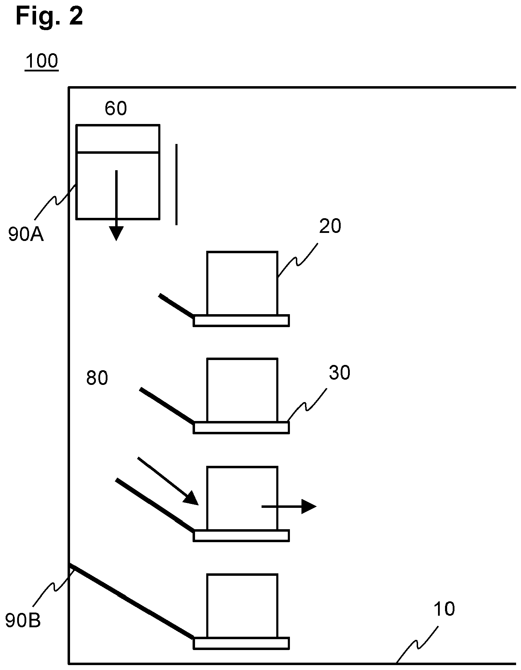

The at least one second channel 60 comprises a plurality of first flow guide elements 90A configured to guide the flow into a third channel 80 (Fig. 2) and divide the flow into separate downward flows for each stack of battery cells 20. In an example embodiment, the third channel 80 comprises the vertical space between the rack arrangement 30 and the wall of the container 10. In an example embodiment, the first flow guide elements 90A comprise sheet metal, such as steel.

In an example embodiment, the first flow guide elements 90A comprise flow guides with a first part inclined with reference to the general flow direction in the at least one second channel 60 and a second part perpendicular to the flow direction in the at least one second channel 60. The length of the first part of a first flow guide element 90A is in an embodiment dependent on the distance of said first flow guide element 90A from the outlet opening 70 in such a way that the length increases with increasing distance. The length of the second part of a first flow guide element 90A is in an embodiment dependent on the distance of said first flow guide element 90A from the outlet opening 70 in such a way that the length increases with increasing distance.

In an example, the angle between the first and second part of the first flow guide elements 90A is between 120 and 150 degrees, for example 135 degrees. In an example, the length of the first part of the first flow guide elements 90A part is from 100 mm to 180mm.

The first flow guide elements 90A is configured to divide the flow into separate downward flows, or diffuse the flow over the area the third channel 80 in such a way that the mass flow of each downward flow, i.e. the mass flow in every position of the cross-section of the third channel 80, is substantially the same so that for each stack of batter cells 20 a same amount of air flow is provided.

Fig. 2 shows a schematic partial cross sectional view of a test facility 100 for testing battery cells according to an example embodiment. Fig. 2 shows the container 10 containing the test chamber with the rack arrangement 30 supporting the battery cells 20 being tested.

The third channel 80 is shown between the rack arrangement 30 and the wall of the container 10. The air flow diffused and turned downward from the second channel 60 into the third channel80 by the first flow guide elements 90A is shown schematically with arrows in Fig. 2.

In an example embodiment, the third channel 80 comprises a plurality of second flow guide elements 90B. In an example embodiment, the second flow guide elements 90B comprise sheet metal, such as steel.

In an example embodiment, the second flow guide elements 90B are configured to guide the downward flow into a horizontal flow on or around the battery cells in such a way that the mass flow of the flow on or around each battery cell is substantially same.

In an example embodiment, the second flow guide elements 90B comprise flow guide plates inclined with respect to the flow direction in the third channel 80. In an example embodiment, the second flow guide elements 90B are dimensioned in such a way that their length increases with increasing distance from the second top of the test chamber.

In an example, the distance of the tip of the second flow guide elements 90B from the rack arrangement is between 100mm and the whole width of the third channel and the angle of inclination with respect to the horizontal plane is between 115 and 145 degrees.

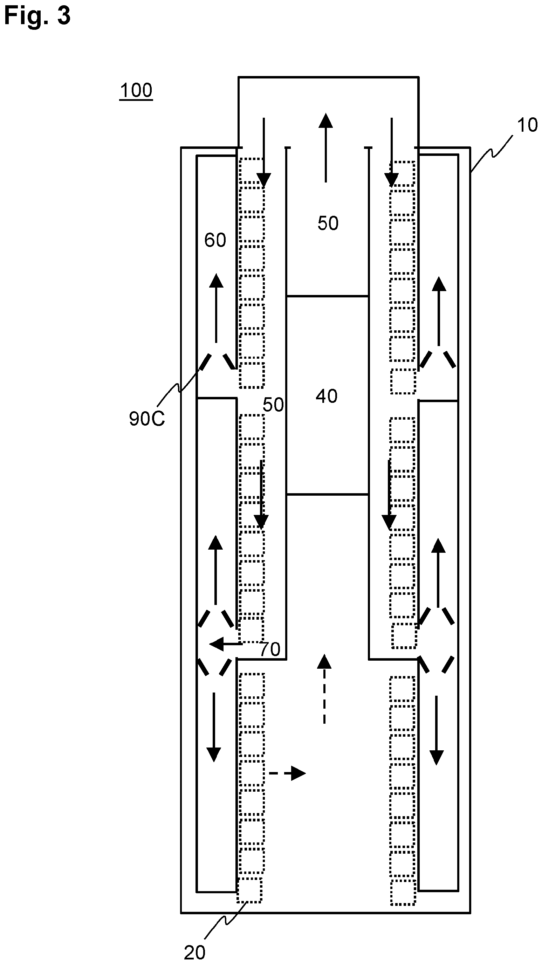

Fig. 3 shows a schematic top view of a test facility 100 for testing battery cells according to an example embodiment. Fig. 2 shows the container 10 containing the test chamber with the battery cells 20 being tested.

Fig. 3 shows the air flow generated by the arrangement 40 first guided into a first channel 50 running horizontally from the arrangement 40 on the roof of the container 10 and then turning at the end of the container 10 to run further horizontally on top of the test chamber on both sides thereof within the container 10. The directions of air flow are schematically shown with arrow in Fig. 3.

The first channel 50 comprises at least one outlet opening 70 configured to guide the airflow from the first channel 50 into at least one second channel 60. The at least one second channel 60 comprises a horizontal channel running on top of the test chamber between the first channel 50 and the wall of the container 10.

The at least one second channel further 60 comprises third flow guide elements 90C positioned in the second channel 60 after the inlet opening 70. In an example embodiment, the third flow guide elements 90C are configured to function as flow dampeners controlling the volume flow in the second channel 60 prior to the first flow guide elements 90A.

In an example embodiment, the third flow guide elements 90C comprise a pair of flow guide plates inclined toward each other in the flow direction to form a kind of a funnel. In an example embodiment, the third flow guide elements 90C comprise sheet metal, such as steel.

In an example, each flow guide plate of the third flow guide elements 90C comprises a plate having a length between 100 mm and 300mm. In an example, each flow guide plate of the third flow guide elements 90C has an angle with respect to the plane perpendicular to the flow direction between 55 and 85 degrees.

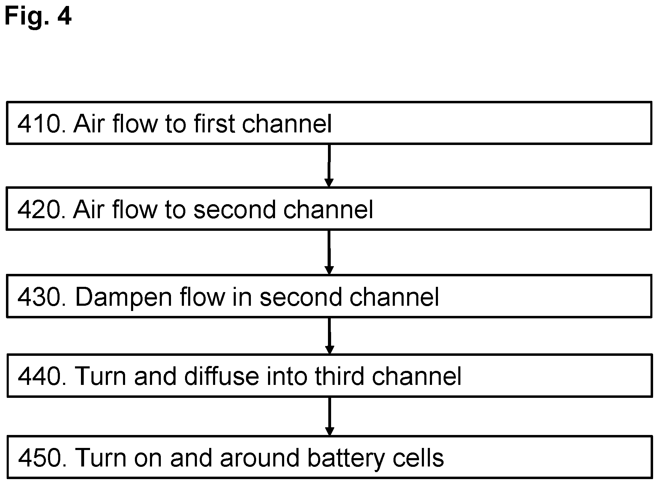

Fig. 4 shows a flow chart of a method of controlling the conditions of a test facility for testing battery cells according to an example embodiment. In an example embodiment, a control system with a user interface for operating the test facility is configured to cause carrying out the method.

At step 410 an air flow is provided into a first channel 50 with an arrangement for providing an airflow 40.

At step 420, the air flow is guided into at least one second channel 60 via at least one inlet opening 70.

At step 430, the air flow is dampened with third flow guide elements 90C in the at least one second channel 60.

At step 440, the air flow is turned downwards into a third flow channel 80 with a plurality of first flow guide elements 90A and separated or diffused into downward flow in such a way that the mass flow on each portion of the third channel, i.e. for each stack of battery cells 20 being tested is substantially the same.

At step 450, the air flow in the third channel 80 is turned on and around each battery cell being tested with a plurality of second flow guide elements 90B in such a way that the mass flow on and around each battery cell 20 being tested is substantially the same.

Without in any way limiting the scope of the appended claims, some technical effects of the environmental monitoring method according to example embodiment are explained in the following.

The test facility and method according to example embodiments is configured to provide each battery cell being tested with the same environmental conditions by providing substantially same air flow on and around each battery cell. The test facility and method according to example embodiments is further configured to provide an easy, space saving and cost effective solution for standardizing the test conditions.

Accordingly, a technical effect of example embodiment of the invention is the provision of standardized test conditions for a large number of battery cells. A further technical effect of the example embodiments of the invention is to decrease the amount of space need for testing. A still further technical effect of the example embodiments of the invention is to provide a flexible way for testing with easy installation of cells for testing. A still further technical effect of the example embodiments of the invention is to improve the testing conditions.

Various embodiments have been presented. It should be appreciated that in this document, words comprise; include; and contain are each used as open-ended expressions with no intended exclusivity.

The foregoing description has provided by way of non-limiting examples of particular implementations and embodiments a full and informative description of the best mode presently contemplated by the inventors for carrying out the invention. It is however clear to a person skilled in the art that the invention is not restricted to details of the embodiments presented in the foregoing, but that it can be implemented in other embodiments using equivalent means or in different combinations of embodiments without deviating from the characteristics of the invention.

Furthermore, some of the features of the afore-disclosed example embodiments may be used to advantage without the corresponding use of other features. As such, the foregoing description shall be considered as merely illustrative of the principles of the present invention, and not in limitation thereof. Hence, the scope of the invention is only restricted by the appended patent claims.

## Claims

1. A modular test facility for testing of battery cells, comprising
a container (10) having a floor, walls and a roof;
at least one rack arrangement (30) in the container configured to support a plurality of battery cells (20) being tested spaced from each other in rows and stacks;
an arrangement (40) configured to provide an airflow into a first channel (50); wherein
the first channel (50) comprises at least one outlet opening (70) configured to guide the airflow into at least one second channel (60); **characterized in that**
the at least one second channel (60) comprises a plurality of first flow guide elements (90A) configured to guide the flow into a third channel (80) and divide the flow into separate downward flows for each stack of battery cells, wherein the mass flow of each downward flow is substantially same; and **in that**
the third channel (80) comprises a plurality of second flow guide elements (90B) configured to guide the downward flow into a horizontal flow on or around each battery cell in such a way that the mass flow of the flow on or around each battery cell is substantially same.

2. A modular test facility of claim 1, wherein the at least one second channel (60) further comprises after the inlet opening (70) third flow guide elements (90C) configured to function as flow dampeners controlling the volume flow in the second channel (60) prior to the first flow guide elements (90A).

3. A modular test facility of claim 1 or 2, further comprising an arrangement for connecting each battery cell (20) being tested to a testing system for cell charging and discharging, control and measurement.

4. A modular test facility of claim 3, further comprising a quick-loading single-cell contactor configured to be adjustable for different types of cells for attaching a battery cell to the testing system.

5. A modular test facility of any preceding claim, wherein the rack arrangement (30) is configured to enable loading and unloading therefrom and connecting and disconnecting each battery cell (20) being tested without affecting the neighbouring cells being tested.

6. A modular test facility of any preceding claim, further comprising in the test chamber within the container (10) a fire detection and suppression system, a gas detection system, a video monitoring system and/or a control system with a user interface for operating the test facility.

7. A method of controlling the conditions of a test facility for testing battery cells,
comprising
providing at least one rack arrangement (30) configured to support a plurality of battery cells (20) being tested spaced from each other in rows and stacks in a container (10);
providing an airflow into a first channel (50);
guiding the airflow into at least one second channel (60) via at least one inlet opening (70);
guiding the flow into a third channel (80) and dividing the flow into separate downward flows for each stack of battery cells, wherein the mass flow of each downward flow is substantially same with a plurality of first flow guide elements (90A); and
guiding the downward flow into a horizontal flow on or around each battery cell in such a way that the mass flow of the flow on or around each battery cell is substantially same with a plurality of second flow guide elements (90B).

8. Method of controlling the conditions of a test facility for testing battery cells of any preceding claim, further comprising dampening the air flow in the at least one second channel (60) with third flow guide elements (90C) prior to the first flow guide elements (90A).
